# EUROPÄISCHE PATENTSCHRIFT

(11) **EP 0 753 936 B1**
(45) Veröffentlichungstag und Bekanntmachung des Hinweises auf die Patenterteilung: **16.01.2002**
(21) Anmeldenummer: 96201887.5
(22) Anmeldetag: 04.07.1996
(51) Int. Cl.: H03F 3/68

(54) **Schaltungsanordnung zum Übertragen von Tonsignalen**
Audio signal transmission circuit
Circuit de transmission de signaux audio

(30) Priorität: 12.07.1995 DE 19525410
(43) Veröffentlichungstag der Anmeldung: 15.01.1997
(73) Patentinhaber: Philips Corporate Intellectual Property GmbH, 52064 Aachen (DE); Koninklijke Philips Electronics N.V., 5621 BA Eindhoven (NL)
(72) Erfinder: Dünnebacke, Joachim, Röntgenstrasse 24 22335 Hamburg (DE); Schwantes-Roy, Dirk, Röntgenstrasse 24 22335 Hamburg (DE)
(74) Vertreter: Peters, Carl Heinrich, Dipl.-Ing.

(56) Entgegenhaltungen:
- EP-A- 0 613 242

## Beschreibung

Die Erfindung bezieht sich auf eine Schaltungsanordnung zum Übertragen von Tonsignalen.

Aus der EP 0 613 242 A1 ist ein selbstkonfigurierbarer Doppelbrücken-Leistungsverstärker bekannt, der zum Speisen zweier Lautsprecher eingerichtet ist.
Der Verstärker kann durch eine Mehrzahl von Konfigurationsschaltern wahlweise als Einzelbrückenverstärker zum Speisen der beiden Lautsprecher in Reihenschaltung oder als Anordnung mit zwei getrennten Brückenverstärkern betrieben werden, von denen jeder einen der Lautsprecher speist. Dabei wird im erstgenannten Fall eine Mittenanzapfung der Reihenschaltung der Lautsprecher mit einem Bezugspotential verbunden, so daß der genannte Einzelbrückenverstärker als Zusammenschaltung zweier Eintaktverstärker wirkt. Solange die Pegel von dem Verstärker zugeführten Eingangssignalen in einem Intervall zwischen zwei Referenzspannungen bleiben, arbeitet der Verstärker als Einzelbrücken- bzw. doppelter Eintaktverstärker. Überschreitet der Pegel der Eingangssignale die genannten Referenzspannungen, wird der Verstärker als Doppelbrückenverstärker betrieben.

Mit einer derartigen Verstärkeranordnung soll erreicht werden, daß für geringe Signalamplituden die Verluste in den Verstärkerstufen reduziert werden.

An eine Verstärkeranordnung der bekannten Art kann vorteilhaft ein Lautsprecherpaar für einen Stereokanal für die Tonwiedergabe in einem Kraftfahrzeug oder dgl. angeschlossen sein, wobei einer der Lautsprecher bevorzugt im vorderen Teil und der zweite Lautsprecher im hinteren Teil des zu beschallenden Raumes angeordnet wird. Die Verstärkeranordnung bildet dann für jeden Lautsprecher je nach Amplitude des verarbeiteten Tonsignals einen Eintakt- bzw. einen Brückenverstärker, wobei den Lautsprechern unterschiedliche Signale, insbesondere auch Signale unterschiedlicher Amplituden, zugeführt werden können. In der als erste Betriebsart bezeichneten Konfiguration der Verstärkeranordnung als zwei Eintaktverstärker mit in Reihe geschaltetem Lautsprecherpaar liegt am Knotenpunkt ("Anzapfung", siehe oben) der Lautsprecher nur das beschriebene Bezugspotential, jedoch kein Tonsignal. Erst im Brückenbetrieb, auch als zweite Betriebsart bezeichnet, in dem die Verstärkeranordnung zwei Brückenverstärker für je einen Lautsprecher bildet, wird jedem der Lautsprecheranschlüsse über eine Stufe der Verstärkeranordnung ein Tonsignal zugeführt.

Die mit der Verstärkeranordnung verbundenen Lautsprecher stellen jeder für sich eine symmetrische Signalsenke dar. Werden sie durch ebenfalls symmetrische Signalsenken anderer Baumformen ersetzt, ergibt sich für die Verstärkeranordnung eine entsprechende Betriebsweise, da symmetrische Eingänge nur die Differenz der Eingangssignale verarbeiten und es somit unbedeutend ist, ob ein Anschluß eines symmetrischen Eingangs ein Tonsignal oder ein Bezugspotential zugeführt erhält. Andere Verhältnisse ergeben sich jedoch beim Anschluß von Signalsenken mit unsymmetrischen Eingängen.

Bei einer räumlichen Trennung zwischen Signalqulle (Autoradio) und einem Zusatzverstärker (Soundsystem) werden häufig Endstufen des Autoradios als Treiber genutzt, um für die Übertragung auf den Zuleitungen zu dem Zusatzverstärker hohe Signalpegel und damit große Störabstände zu erreichen. Außerdem ist es dann möglich, ungeschirmte Leitungen zu verwenden. Wenn die Eingänge dieser Soundsysteme symmetrisch ausgebildet sind, d.h., daß sie für jeden Kanal, d.h. für jeden Lautsprecher, einen positiven und einen negativen Eingang aufweisen, können sie problemlos an die Ausgänge des bekannten, eingangs beschriebenen Signalverstärkers angeschlossen werden.

Völlig anders verhält sich die Situation jedoch, wenn aus Gründen der Vereinfachung das Soundsystem einen unsymmetrischen Eingang aufweist. Dieser Fall ergibt sich insbesondere bei älteren Produkten, die auf Signalquellen, insbesondere Autoradions, abgestimmt sind, die lediglich Eintakt-Endstufen aufweisen. Die Ausgangsanschlüsse dieser Eintakt-Endstufen sind ebenfalls unsymmetrisch, so daß für einen Anschluß daran ein Soundsystem mit unsymmetrischen Eingängen sinnvoll ist. In diesem Fall werden die Eingänge des Soundsystems mit den gewünschten Signalen phasenrichtig angesteuert.

Es treten jedoch Schwierigkeiten auf, wenn beispielsweise in einem Kraftfahrzeug mit einem derartigen Soundsystem mit unsymmetrischen Eingängen ein Autoradio neueren Fabrikats eingesetzt werden soll, welches als Endstufe einen Signalverstärker der eingangs beschriebenen Art mit symmetrischen Ausgängen aufweist. Es zeigt sich dann, daß ein Teil der Kanäle des Soundsystems, d.h. ein Teil der Lautsprecher, kein Tonsignal mehr zugeführt erhält, wenn sich der Signalverstärker in der ersten Betriebsart befindet. In dieser Form sind somit Geräte mit einem Signalverstärker der eingangs beschriebenen Art mit Leitungstreibern bzw. Soundsystemen mit unsymmetrischen Eingängen nicht kombinierbar.

Die Erfindung hat die Aufgabe, mit einfachen Mitteln eine Möglichkeit zu schaffen, die genannten Anordnungen störungsfrei miteinander kombinieren und gemeinsam betreiben zu können.

Diese Aufgabe wird erfindungsgemäß gelöst durch eine Schaltungsanodnung zum Übertragen von Tonsignalen mit einem Signalverstärker,
- der vier Leistungsverstärker mit je einem Eingang und je einem Ausgang umfaßt, von denen ein erster und ein dritter für ihnen zugeführte Tonsignale nicht invertierend und ein zweiter und ein vierter invertierend ausgebildet sind, wobei den Eingängen des ersten und zweiten Leistungsverstärkers ein erstes Tonsignal und den Eingängen des dritten und vierten Leistungsver stärkers ein zweites Tonsignal zuführbar ist,
- in dem in einer ersten Betriebsart bei Tonsignalen geringer Amplituden der erste und der vierte Leistungsverstärker je einen Eintaktverstärker bilden und die Ausgänge des zweiten und/oder dritten Leistungsverstärkers ein Bezugspotential führen und
- in dem in einer zweiten Betriebsart bei Tonsignalen großer Amplituden der erste und zweite Leistungsverstärker einen ersten Brückenverstärker und der dritte und vierte Leistungsverstärker einen zweiten Brückenverstärker bilden,
- wobei die Ausgänge des ersten und des zweiten Leistungsverstärkers zum Anschluß einer ersten Signalsenke und die Ausgänge des dritten und des vierten Leistungsverstärkers zum Anschluß einer zweiten Signalsenke vorgesehen sind,
- mit einer Zwangsumschaltung in die zweite Betriebsart, wenn die Signalsenken weitere Verstärkeranordnungen umfassen.

Die Erfindung ermöglicht es, einen selbstkonfigurierbaren Signalverstärker mit symmetrischen Ausgängen ohne Veränderung der Schaltungsanordnung sowohl mit einer Eingangsschaltung mit symmetrischen als auch mit unsymmetrischen Eingängen zu betreiben. Bei einem nachträglichen Einbau bzw. Austausch von Komponenten, beispielsweise einer Autoradioanlage, sind daher keinerlei Anpassungsarbeiten an den bestehenden oder den neu einzubauenden Einrichtungen erforderlich. Es muß lediglich dafür gesorgt werden, daß zumindest beim Speisen einer Eingangsschaltung mit unsymmetrischen Eingängen der speisende Signalverstärker zwangsweise für alle Amplituden der zu verarbeitenden Tonsignale in der zweiten Betriebsart, d.h. im Brückenbetrieb, arbeitet. Dies ist ohne Beeinträchtigungen der Funktionsweise und der Wiedergabequalität der Tonsignale möglich, da die Eingangsschaltung der Soundsysteme wesentlich höhere Eingangswiderstände als Lautsprecher aufweisen und somit die Verlustleistungen im Signalverstärker von vornherein wesentlich kleiner sind.

Die Erfindung kann selbstverständlich auch angewendet werden auf Anordnungen von Signalverstärkern, die mehrere Gruppen von je vier Leistungsverstärkern aufweisen. Wird ein Signalverstärker mit vier Leistungsverstärkern bevorzugt für die Aussteuerung zweier Lautsprecher (z.B. vorne und hinten) eines Stereokanals verwendet, können Signalverstärkeranordnungen mit mehreren Gruppen von je vier Leistungsverstärkern für die Verarbeitung mehrkanaliger Stereosignale herangezogen werden.

Vorzugsweise erfolgt die Zwangsumschaltung in die zweite Betriebsart bei Autoradio-Soundsystem-Kombinationen. An das Autoradio wird bevorzugt wenigstens ein Zusatzverstärker über Leitungen angeschlossen. Jedoch können die Tonwiedergabevorrichtungen, insbesondere Lautsprecher, auch unmittelbar mit dem Signalverstärker verbunden werden. Die Erfindung ermöglicht dabei eine größtmögliche Gestaltungsfreiheit.

Obgleich die Erfindung bevorzugt für die Verwendung von Signalsenken mit unsymmetrischen Eingängen ausgelegt ist, ist in gleicher Weise ein Betrieb auch mit Signalsenken mit symmetrischen Eingängen möglich. Die erfindungsgemäße Zwangsumschaltung kann dabei einerseits ausschließlich in den Fällen wirksam sein, in denen eine solche Signalsenke mit unsymmetrischen Eingängen vorliegt. Wie sich jedoch aus dem Vorstehenden bereits ergibt, können grundsätzlich alle Signalsenken, die weitere Verstärkeranordnungen umfassen und daher relativ hochohmige Eingänge aufweisen, die Zwangsumschaltung der Signalquelle (Autoradio) in die zweite Betriebsart veranlassen. Dadurch ergeben sich einerseits kaum höhere Verluste, andererseits können sich jedoch konstruktive Vereinfachungen ergeben. Dies wird im Nachfolgenden näher erläutert.

Vorteilhaft kann der Signalquelle (Autoradio) zur Zwangsumschaltung in die zweite Betriebsart ein Steuersignal zuführbar sein. Dieses Steuersignal kann beispielsweise aus dem Soundsystem stammen. Das Steuersignal kann andererseits auch über einen Datenbus zugeführt werden. Das bedingt jedoch, daß das Soundsystem oder das Radio zur Abgabe eines derartigen Steuersignals eingerichtet oder daß ein Datenbus der genannten Art vorhanden sein müssen. Dies wird jedoch in der Regel nicht der Fall sein. Vorteilhaft wird daher ein entsprechendes Steuersignal von der erfindungsgemäßen Schaltungsanordnung bzw. einer Weiterbildung derselben erzeugt werden müssen.

Eine Weiterbildung der Erfindung, die eine solche Erzeugung eines Steuersignals in möglichst einfacher, von den übrigen Teilen beispielsweise der Autoradioanlage unabhängigerweise vorsieht, weist eine Meß- und Steuerschaltung zur Messung der durch die Signalsenken an den Ausgängen der Leistungsverstärker hervorgerufenen Lastimpedanzen und zur Umschaltung in die zweite Betriebsart auf, wenn die Lastimpedanzen einen vorgebbaren Wert übersteigen. Für den Anschluß eines Soundsystems für zwei Lautsprecher, d.h. mit zwei Kanälen, können dann auch zwei Impedanzen gemessen werden. Übersteigen beide Impedanzwerte den vorgegebenen Wert, erkennt die Meß- und Steuerschaltung, daß ein Leitungstreiber bzw. ein Soundsystem angeschlossen ist, wobei die Bauart des Leitungstreiberssymmetrische oder unsymmetrische Eingänge - im einfachsten Fall ohne Bedeutung ist. Somit ist beim Einsatz einer derartigen Meß- und Steuerschaltung eine Zwangsumschaltung in die zweite Betriebsart bei jedem Leitungstreiber unabhängig von der Gestaltung von dessen Eingängen am einfachsten, wo hingegen eine Erkennung und Unterscheidung zwischen symmetrischen und unsymmetrischen Eingängen einen größeren Aufwand bedeutet, ohne daß dadurch der Nutzen, eine geringere Verlustleistung, nennenswert erhöht würde.

Andererseits kann eine Messung zweier Impedanzen gegebenenfalls auch für eine Fehlererkennung herangezogen werden. Ein Fehler wird beispielsweise immer dann erkannt, wenn eine der gemessenen Impedanzen oberhalb und die zweite unterhalb des vorgebbaren Wertes liegt.

Die Zeichnung dient zur Erläuterung eines Ausführungsbeispiels der Erfindung und zeigt in
- Fig. 1: eine blockschematische Darstellung eines Signalverstärkers, wie er für die Erfindung verwendet wird,
- Fig. 2: eine Kopplung des Signalverstärkers nach Fig. 1 mit einem Soundsystem mit symmetrischen Eingängen,
- Fig. 3: eine vereinfachte Darstellung einer Zusammenschaltung eines Signalverstärkers und eines Soundsystems mit unsymmetrischen Eingängen,
- Fig. 4: eine Zusammenschaltung eines Signalverstärkers gemäß Fig. 1 mit einem Soundsystem mit unsymmetrischen Eingängen gemäß Fig. 3 in der ersten Betriebsart des Signalverstärkers und
- Fig. 5: die Anordnung nach Fig. 4 in der zweiten Betriebsart des Signalverstärkers.

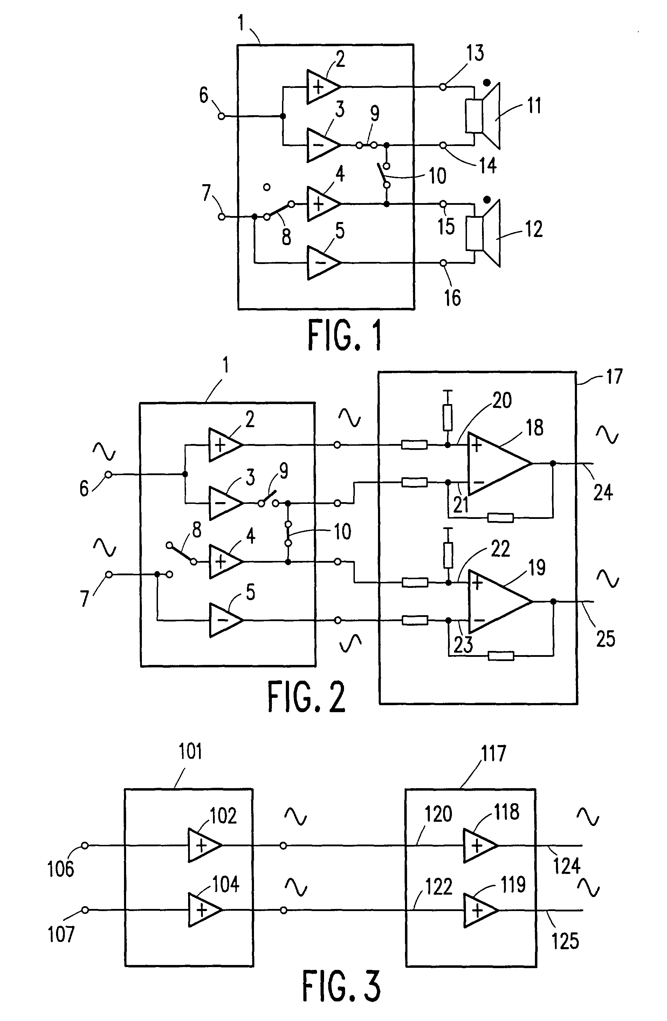

Fig. 1 zeigt blockschematisch eine Anordnung eines Signalverstärkers 1, wie er grundsätzlich aus der EP 0 613 242 A1 bekannt ist. Der Signalverstärker 1 weist einen ersten, nicht invertierenden Leistungsverstärker 2, einen zweiten, invertierenden Leistungsverstärker 3, einen dritten, nicht invertierenden Leistungsverstärker 4 sowie einen vierten, invertierenden Leistungsverstärker 5 auf. Der erste und der zweite Leistungsverstärker 2, 3 sind mit ihren Eingängen an einen ersten Tonsignaleingang 6, der dritte und der vierte Leistungsverstärker 4, 5 sind mit ihren Eingängen an einen zweiten Tonsignaleingang 7 angeschlossen. Dabei erfolgt der Anschluß des Eingangs des dritten Leistungsverstärkers 4 über einen ersten Schalter 8, der als Umschalter ausgebildet ist und durch den der Eingang des dritten Leistungsverstärkers 4 wahlweise mit dem zweiten Tonsignaleingang 7 oder mit einem Bezugspotential verbindbar ist. Ein erster Lautsprecher 11, der eine erste Signalsenke bildet, ist mit seinen Anschlüssen 13, 14 an die Ausgänge des ersten bzw. des zweiten Leistungsverstärkers 2 bzw. 3 angeschlossen. Entsprechend ist ein zweiter, eine zweite Signalsenke bildender Lautsprecher 12 mit seinen Anschlüssen 15 bzw. 16 an die Ausgänge des dritten bzw. des vierten Leistungsverstärkers 4 bzw. 5 angeschlossen. Mit Punkten ist die Polung der Lautsprecher 11, 12 angedeutet. Die Verbindung zwischen dem Ausgang des zweiten Leistungsverstärkers 3 und dem Anschluß 14 des ersten Lautsprechers 11 erfolgt über einen zweiten Schalter 9, der als Ausschalter ausgebildet ist. Ein dritter, ebenfalls als Ausschalter ausgebildeter Schalter 10 stellt wahlweise eine Verbindung zwischen den Ausgängen des zweiten und des dritten Leistungsverstärkers 3, 4 bzw. zwischen den Anschlüssen 14 und 15 der Lautsprecher 11, 12 her.

Wie in der EP 0 613 242 A1 näher beschrieben, kann der Signalverstärker 1 zwei Betriebsarten einnehmen. In der zweiten Betriebsart, in der die Schalter 8, 9, 10 die gezeigte Stellung aufweisen, bilden der erste und der zweite Leistungsverstärker 2, 3 einerseits für den ersten Lautsprecher 11 (d.h. die erste Signalsenke) und der dritte und vierte Leistungsverstärker 4, 5 andererseits für den zweiten Lautsprecher 12 (d.h. die zweite Signalsenke) je einen Brückenverstärker, durch die die Lautsprecher 11, 12 unabhängig voneinander durch die den Tonsignaleingängen 6, 7 zugeführten Tonsignale gespeist werden können. Beispielsweise wird ein solcher Signalverstärker 1 in einem Kraftfahrzeug zum Speisen eines Frontlautsprechers und eines Hecklautsprechers für einen Stereokanal mit zumindest in der Amplitude voneinander abweichenden Tonsignalen eingesetzt.

In der ersten Betriebsart nehmen die Schalter 8, 9, 10 ihre zu den in Fig. 1 gezeigten Stellungen jeweils entgegengesetzte Stellung ein. Durch den ersten Schalter 8 wird somit dem Eingang des dritten Leistungsverstärkers 4 das Bezugspotential zugeleitet, der zweite Schalter 9 unterbricht das Signal am Ausgang des zweiten Leistungsverstärkers 3 und der dritte Schalter 10 verbindet die Anschlüsse 14 und 15 der Lautsprecher 11, 12 miteinander (und mit dem Ausgang des dritten Leistungsverstärkers 4). In dieser ersten Betriebsart bildet der Signalverstärker 1 zwei Eintaktverstärker für die beiden Lautsprecher 11, 12, wobei der dritte Leistungsverstärker 4 als Pufferverstärker zur Übertragung des Bezugspotentials an die verbundenen Anschlüsse 14, 15 dient.

Vorzugsweise wird die erste Betriebsart für niedrige Amplituden der Tonsignale an den Tonsignaleingängen 6, 7, die zweite Betriebsart für hohe Amplituden dieser Tonsignale verwendet.

Fig. 2, in der bereits erläuterte Elemente wieder mit denselben Bezugszeichen versehen sind, zeigt eine Verbindung des Signalverstärkers 1 mit symmetrischen Eingängen beispielsweise eines Soundsystems für ein Autoradio. Diese mit dem Bezugszeichen 17 bezeichnete Eingangsschaltung weist für jeden Kanal einen Verstärker 18 bzw. 19, beispielsweise als Operationsverstärker ausgebildet, auf. Die Verstärker 18, 19 sind in an sich bekannter Weise mit Eingangs- und Rückkopplungswiderständen beschaltet. Dabei ist ein nichtinvertierender Eingang 20 des ersten Verstärkers 18 mit dem Ausgang des ersten Leistungsverstärkers 2, ein invertierender Eingang 21 des ersten Verstärkers 18 mit dem Ausgang des zweiten Leistungsverstärkers 3, ein nichtinvertierender Eingang 22 des zweiten Verstärkers 19 mit dem Ausgang des dritten Leistungsverstärkers 4 und ein invertierender Eingang 23 des zweiten Verstärkers 23 des zweiten Verstärkers 19 mit dem Ausgang des vierten Leistungsverstärkers 5 verbunden. Ein Ausgang 24 des ersten Verstärkers 18 führt dann das verstärkte Tonsignal für den ersten Lautsprecherkanal, ein Ausgang 25 des zweiten Verstärkers 19, das verstärkte Tonsignal für den zweiten Lautsprecherkanal. An die Ausgänge 24, 25 können zur weiteren Signalverarbeitung z.B. Filter, Kompressoren, DSP's oder Endstufen unsymmetrisch gegen Masse angeschlossen werden.

In Fig. 2 ist der Signalverstärker 1 in der ersten Betriebsart dargestellt. Die Verstärker 18, 19 der Eingangsschaltung 17 sind dann mit ihren Eingängen 20 bis 23 mit dem Signalverstärker 1 verbunden. Durch Sinussymbole an den Tonsignaleingängen 6, 7, den Ausgängen des ersten und des vierten Leistungsverstärkers 2 bzw. 5 und den Ausgängen 24, 25 ist der Fluß der zu übertragenden Tonsignale angedeutet. Es ist zu erkennen, daß am Ausgang des dritten Leistungsverstärkers 4 und damit an den Eingängen 21 und 22 kein Tonsignal anliegt, die Signalübertragung dadurch jedoch nicht beeinträchtigt ist, da die Eingangsschaltung 17nur die Differenz zwischen den Eingängen 20, 21 bzw. 22, 23 verarbeitet.

Fig. 3 zeigt in vereinfachter, blockschematischer Darstellung eine Abwandlung der Schaltungsanordnung nach Fig. 2 mit einem Signalverstärker 101 in unsymmetrischer Anordnung und eine unsymmetrische Eingangsschaltung 117. Während die Eingangsschaltung 117 wieder zwei Verstärker 118, 119 umfaßt, die jetzt für unsymmetrische Signale angeschlossen sind, enthält der Signalverstärker 101 der unsymmetrischen Ausführung lediglich einen ersten und einen dritten Leistungsverstärker 102, 104 in jeweils nicht invertierender Ausführung. Den Eingängen 20 bzw. 22 der Verstärker 18, 19 des Leitungstreibers 17 in Fig. 2 entsprechen die Eingänge 120 bzw. 122 der Verstärker 118 bzw. 119 der Eingangsschaltung 117 in Fig. 3. Auch bei dieser unsymmetrischen Anordnung ist der Tonsignalfluß schematisch durch Sinussymbole angedeutet. Es ist erkennbar, daß die Signale einwandfrei von den Tonsignaleingängen 6 bzw. 7 entsprechenden Tonsignaleingängen 106 bzw. 107 des Signalverstärkers 101 an den Ausgängen 24 bzw. 25 entsprechende Ausgänge 124, 125 der Eingangsschaltung 117 übertragen werden.

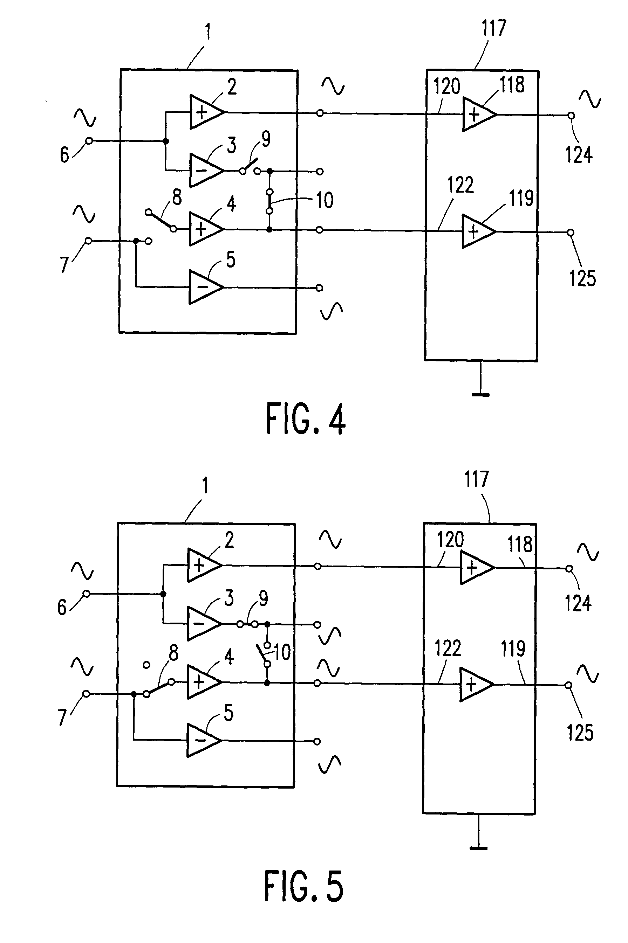

Die Verhältnisse stellen sich jedoch anders dar, wenn, wie in Figur 4, der Signalverstärker 1 gemäß Fig. 2 mit der Eingangsschaltung 117 gemäß Figur 3 gekoppelt wird. Wie anhand der Sinussymbole sofort erkennbar wird, erhält der Engang 122 und somit auch der Ausgang 125 des zweiten Verstärkers 119 der Eingangsstufe 117 in der hier dargestellten, ersten Betriebsart kein Tonsignal. Diesem Mißstand kann auch nicht einfach dadurch abgeholfen werden, daß der Eingang 122 des zweiten Verstärkers 119 statt mit dem Ausgang des dritten Leistungsverstärkers 4 jetzt dem Ausgang des vierten Leistungsverstärkers 5 verbunden wird, da das Tonsignal am Ausgang 125 dann mit invertierter Phasenlage erscheinen und so die gesamte Tonsignalwiedergabe verfälschen würde.

Fig. 5 zeigt die Schaltungsanordnung nach Fig. 4 in der zweiten Betriebsart. Wieder zeigen die Sinussymbole den Tonsignalfluß, wobei die unterschiedliche Ausführung dieser Sinussymbole gleichzeitig die Phasenlagen der Tonsignale andeutet. Es ist erkennbar, daß jetzt an den Ausgängen 124, 125 phasenrichtige Tonsignale erscheinen. Somit kann der in Fig. 4 dargestellte Mißstand sehr einfach dadurch behoben werden, daß durch die erfindungsgemäße Zwangsumschaltung der Signalverstärker 1 stets in der zweiten Betriebsart gehalten wird. Dadurch kann eine korrekte Übertragung der Tonsignale bei einer Kombination eines Signalverstärkers 1 sowohl mit einer Eingangsstufe 17 gemäß Fig. 2 als auch mit einer Eingangsstufe 117 (in unsymmetrischer Ausbildung) gemäß den Figuren 4 oder 5 fehlerfrei betrieben werden, ohne daß zusätzliche Anpaßarbeiten erforderlich sind. Dies ist beispielsweise sehr vorteilhaft, wenn in einer Soundanlage älteren Typs die Signalquelle (Autoradio) einschließlich des Signalverstärkers 101 gegen ein verbessertes Modell mit einem Signalverstärker 1 ausgetauscht werden soll. Die Verbindungen können dann für beide Autoradiomodelle identisch vorgenommen werden.

Darüberhinaus hat die Zwangsumschaltung in die zweite Betriebsart, d. h. den Betrieb als zweifacher Brückenverstärker, beim Anschluß eines Soundsystems auch den Vorteil, daß Störungen, die gegebenenfalls beim Schalten zwischen den beiden Betriebsarten im Tonsignal auftreten können und durch die eventuell höhere Leistung und bessere Lautsprecher hörbar wären, von vornherein vermieden werden. Daher kann erfindungsgemäß eine Zwangsumschaltung auch dann erfolgen, wenn eine Eingangsschaltung 17 mit symmetrischen Eingängen zum Einsatz kommt.

## Patentansprüche

1. Schaltungsanodnung zum Übertragen von Tonsignalen mit einem Signalverstärker (1),
- der vier Leistungsverstärker (2, 3, 4, 5) mit je einem Eingang und je einem Ausgang umfaßt, von denen ein erster (2) und ein dritter (4) für ihnen zugeführte Tonsignale nicht invertierend und ein zweiter (3) und ein vierter (5) invertierend ausgebildet sind, wobei den Eingängen des ersten (2) und zweiten (3) Leistungsverstärkers ein erstes Tonsignal und den Eingängen des dritten (4) und vierten (5) Leistungsverstärkers ein zweites Tonsignal zuführbar ist,
- in dem in einer ersten Betriebsart bei Tonsignalen geringer Amplituden der erste (2) und der vierte (5) Leistungsverstärker je einen Eintaktverstärker bilden und die Ausgänge des zweiten (3) und/oder dritten (4) Leistungsverstärkers ein Bezugspotential führen und
- in dem in einer zweiten Betriebsart bei Tonsignalen großer Amplituden der erste (2) und zweite (3) Leistungsverstärker einen ersten Brückenverstärker und der dritte (4) und vierte (5) Leistungsverstärker einen zweiten Brückenverstärker bilden,
- wobei die Ausgänge des ersten (2) und des zweiten (3) Leistungsverstärkers zum Anschluß einer ersten Signalsenke (11) und die Ausgänge des dritten (4) und des vierten (5) Leistungsverstärkers zum Anschluß einer zweiten Signalsenke (12) vorgesehen sind,
**gekennzeichnet durch** eine Zwangsumschaltung in die zweite Betriebsart, wenn die Signalsenken (11, 12) weitere Verstärkeranordnungen umfassen.

2. Schaltungsanordnung nach Anspruch 1,**dadurch gekennzeichnet, daß** die Zwangsumschaltung in die zweite Betriebsart bei *einer Kombination eines eine Signalquelle bildenden Autoradios mit einem auch als Soundsystem bezeichneten Zusatzverstärker* erfolgt.

3. Schaltungsanordnung nach Anspruch 2
zum Anschluß wenigstens einer Tonwiedergabevorrichtung über je eine Leitung an *den auch als Soundsystem bezeichneten Zusatzverstärker.*

4. Schaltungsanordnung nach Anspruch 2 oder 3,
**dadurch gekennzeichnet, daß** die Signalsenken unsymmetrische Eingänge aufweisen.

5. Schaltungsanordnung nach einem der *Ansprüche 2 bis 4,*
**dadurch gekennzeichnet, daß** *dem die Signalquelle bildenden Autoradio* zur Zwangsumschaltung in die zweite Betriebsart ein Steuersignal zuführbar ist.

6. Schaltungsanordnung nach einem der Ansprüche 1 bis 4,
**gekennzeichnet durch** eine Meß- und Steuerschaltung zur Messung der **durch** die Signalsenken an den Ausgängen der Leistungsverstärker hervorgerufenen Lastimpedanzen und zur Zwangsumschaltung in die zweite Betriebsart, wenn die Lastimpedanzen einen vorgebbaren Wert übersteigen.

## Claims

1. A circuit arrangement for transmitting audio signals, having a signal amplifier
- comprising four power amplifiers (2, 3, 4, 5) each having an input and an output, of which a first one (2) and a third one (4) are non-inverting and of which a second one (3) and a fourth one (5) are inverting for audio signals applied to them, the inputs of the first (2) and the second (3) power amplifier being arranged to receive a first audio signal and the inputs of the third (4) and the fourth (5) power amplifier being arranged to receive a second audio signal,
- in which, in a first configuration mode for audio signals of low amplitude, the first (2) and the fourth (5) power amplifier each form a single-ended amplifier and the outputs of the second (3) and/or the third (4) power amplifier carry a reference potential, and
- in which, in a second configuration mode for audio signals of higher amplitude, the first (2) and the second (3) power amplifier form a first bridge amplifier and the third (4) and the fourth (5) power amplifier form a second bridge amplifier,
- the outputs of the first (2) and the second (3) power amplifier being arranged for the connection of a first signal sink (11) and the outputs of the third (4) and the fourth (5) power amplifier being arranged for the connection of a second signal sink (12),
**characterized by** an automatic change-over to the second configuration mode if the signal sinks (11, 12) include further amplifier arrangements.

2. A circuit arrangement as claimed in Claim 1, **characterized in that** the automatic change-over to the second configuration mode is effected in a combinations of a car radio, which forms a signal source, and an additional amplifier, which also referred to as a sound system.

3. A circuit arrangement as claimed in Claim 2,
for the connection of at least one sound reproducing device to the additional amplifier, also referred to as a sound system, via one line each.

4. A circuit arrangement as claimed in Claim 2 or 3,
**characterized in that** the signal sinks have asymmetrical inputs.

5. A circuit arrangement as claimed in any one of the Claims 2 to 4,
**characterized in that** the signal source which forms the car radio is arranged to receive a control signal for the automatic change-over to the second configuration mode.

6. A circuit arrangement as claimed in any one of the Claims 1 to 4,
**characterized by** a measurement and control circuit for measuring the load impedances brought about by the signal sinks at the outputs of the power amplifiers and for the automatic change-over to the second configuration mode when the load impedances exceed a given value.

## Revendications

1. Circuit de transmission de signaux audio avec un amplificateur de signaux (1),
- qui comprend quatre amplificateurs de puissance (2, 3, 4, 5) avec respectivement une entrée et une sortie, dont un premier (2) et un troisième (4) sont de conception non inversante pour les signaux audio qui leur sont amenés et un deuxième (3) et un quatrième (5) sont de conception inversante, un premier signal audio pouvant être amené aux entrées des premier (2) et deuxième (3) amplificateurs de puissance et un deuxième signal audio aux entrées des troisième (4) et quatrième (5) amplificateurs de puissance,
- dans lequel les premier (2) et quatrième (5) amplificateurs de puissance forment respectivement un amplificateur à simple alternance et les sorties des deuxième (3) et/ou troisième (4) amplificateurs de puissance conduisent un potentiel de référence dans un premier mode de fonctionnement pour des signaux audio de faible amplitude et
- dans lequel, dans un deuxième mode de fonctionnement pour des signaux audio de grande amplitude, les premier (2) et deuxième (3) amplificateurs de puissance forment un premier amplificateur en pont et les troisième (4) et quatrième (5) amplificateurs de puissance forment un deuxième amplificateur en pont,
- les sorties des premier (2) et deuxième (3) amplificateurs de puissance étant prévues en vue du raccordement d'une première source de signaux (11) et les sorties des troisième (4) et quatrième (5) amplificateurs de puissance pour le raccordement d'une deuxième source de signaux (12),
**caractérisé par** une commutation forcée dans le deuxième mode de fonctionnement lorsque les sources de signaux (11, 12) comprennent d'autres dispositifs amplificateurs.

2. Circuit selon la revendication 1, **caractérisé en ce que** la commutation forcée dans le deuxième mode de fonctionnement intervient pour une *combinaison d'un autoradio formant une source de signaux avec un amplificateur supplémentaire désigné comme un système de sonorisation.*

3. Circuit selon la revendication 2,
pour le raccordement d'au moins un dispositif de reproduction audio par l'intermédiaire d'une ligne à l'*amplificateur supplémentaire désigné comme un système de sonorisation.*

4. Circuit selon l'une des revendications 2 ou 3,
**caractérisé en ce que** les sources de signaux présentent des entrées asymétriques.

5. Circuit selon l'une des revendications 2 à 4,
**caractérisé en ce qu'**un signal de commande peut être amené à l'autoradio formant la source de signaux pour la commutation forcée dans le deuxième mode de fonctionnement.

6. Circuit selon l'une des revendications 1 à 4,
**caractérisé par** un circuit de mesure et de commande pour la mesure des impédances de charge provoquées par les sources de signaux aux sorties de l'amplificateur de puissance et pour la commutation forcée dans le deuxième mode de fonctionnement lorsque les impédances de charge présentent une valeur à déterminer préalablement.
